# EUROPÄISCHE PATENTANMELDUNG

(11) **EP 2 034 386 A1**
(43) Veröffentlichungstag der Anmeldung: **11.03.2009**
(21) Anmeldenummer: 08405214.1
(22) Anmeldetag: 04.09.2008
(51) Int. Cl.: G06F 1/18

(54) **Computergehäuse mit Steckkartenmodul**

(30) Priorität: 07.09.2007 CH 14002007
(71) Anmelder: Digital-Logic AG, 4542 Luterbach (CH)
(72) Erfinder: Kunz, Felix, 4500 Solothurn (CH)
(74) Vertreter: Frei Patent Attorneys

(57) **Zusammenfassung**

Ein Computergehäuse (41) zur freistehenden Verwendung, mit Steckplätzen für die Aufnahme von Erweiterungskarten, weist zur Aufnahme der Erweiterungskarten (51) einen Kartenträger (20) auf, welcher
- eine Träger-Steckverbindung (47) aufweist und über die Träger-Steckverbindung (47) durch Einschieben des Kartenträgers in das Computergehäuse (41) mit einem Kommunikationsanschluss (49) des Computers (10) verbindbar ist,
- mindestens eine Adapter-Steckverbindung (48) aufweist, in welche eine Erweiterungskarte (51) einsteckbar ist,
- wobei der Kartenträger (20) eine Kommunikationsverbindung zwischen der Träger-Steckverbindung (47) und der mindestens einen Adapter-Steckverbindung (48) aufweist.

## Beschreibung

Die Erfindung bezieht sich auf das Gebiet der elektronischen Datenverarbeitungseinrichtungen. Sie bezieht sich insbesondere auf ein Computergehäuse, eingerichtet zur Aufnahme eines Steckkartenmoduls oder Steckkartenträgers gemäss dem Oberbegriff des Patentanspruches 1.

### STAND DER TECHNIK

Computergehäuse sind allgemein bekannt, und bieten oftmals Raum für Erweiterungskarten. Die Schnittstellen für Erweiterungskarten sind normiert, aktuell eingesetzte Normen sind beispielsweise der PCI Standard, der gegenwärtig zum Teil durch den PCI-Express Standard abgelöst wird. Üblicherweise werden Erweiterungskarten in einen Slot eines Motherboards (Hauptplatine) gesteckt, so dass sie senkrecht zur Motherboard angeordnet sind. Zum Einsetzen oder Auswechseln einer Erweiterungskarte muss das Gehäuse aufgeschraubt werden. Zur Kühlung des Computers, insbesondere des Hauptprozessors, aber auch für die Erweiterungskarten, werden Ventilatoren eingesetzt.

WO 02/21888 A1 beschreibt einen Steckkartenträger, bei welchem eine Erweiterungskarte auf einer Einschubkarte eingesteckt werden kann und dann parallel zur Einschubkarte angeordnet ist. Die Einschubkarte und die Erweiterungskarte können dann zusammen in ein Computergehäuse eingeschoben werden und in der gleichen Bewegung in einen Anschlusstecker eingesteckt werden. Führungsschienen des Gehäuses sind als Lichtleiter ausgebildet und werden beleuchtet, um anzuzeigen wenn ein Einschub ausgewechselt werden soll.

### DARSTELLUNG DER ERFINDUNG

Es ist Aufgabe der Erfindung, ein Computergehäuse für einen freistehenden Computer zu schaffen, welches einen einfachen Einbau und Austausch von Erweiterungskarten ermöglicht. Eine weitere Aufgabe ist, dabei eine platzsparende Anordnung der Erweiterungskarten zu ermöglichen. Eine weitere Aufgabe ist es, dabei eine möglichst effiziente Kühlung, insbesondere eine passive Kühlung des Computers zu unterstützen.

Diese Aufgabe löst ein Computergehäuse mit den Merkmalen des Patentanspruches 1. Das Computergehäuse ist somit zur freistehenden Verwendung vorgesehen, also insbesondere nicht für den Einbau in einem Racksystem. Das Gehäuse ist also beispielsweise ein Desktop-Gehäuse oder ein Tower-Gehäuse oder ein Minitower-Gehäuse. Das Computergehäuse weist einen Computer mit Steckplätzen für die Aufnahme von Erweiterungskarten auf, wobei der Computer zur Aufnahme der Erweiterungskarten einen Kartenträger aufweist, welcher
- eine Träger-Steckverbindung aufweist und über die Träger-Steckverbindung durch Einschieben des Kartenträgers in das Computergehäuse mit einem Kommunikationsanschluss des Computers verbindbar ist,
- mindestens eine Adapter-Steckverbindung aufweist, in welche eine Erweiterungskarte einsteckbar ist,
- wobei der Kartenträger eine Kommunikationsverbindung zwischen der Träger-Steckverbindung und der mindestens eine Adapter-Steckverbindung aufweist.

Dadurch wird es möglich, eine Erweiterungskarte auszuwechseln, indem der Kartenträger aus dem Gehäuse herausgezogen und die Erweiterungskarte aus dem Kartenträger ein- oder ausgesteckt wird. Das Gehäuse muss dazu nicht geöffnet werden.

In einer bevorzugten Ausführungsform der Erfindung weist der Kartenträger eine im wesentlichen ebene Trägerplatte auf, wobei die Richtung der Bewegung beim Einstecken und Ausstecken des Träger-Steckverbindung parallel zur Ebene der Trägerplatte verläuft. Eingesteckte Erweiterungskarten sind parallel zur Ebene der Trägerplatte angeordnet. Die Adapter-Steckverbindungen (Stecker der Erweiterungskarten) verlaufen dabei parallel zur Ebene der Träger-Steckverbindung (Stecker des Kartenträgers) und, bezüglich einer Achse senkrecht zur dieser Ebene, um vorzugsweise ±90° oder 180° verdreht. Damit liegen die Platinen von Kartenträger wie auch von Erweiterungskarten parallel zueinander und bilden eine kompakte Einheit, welche mit einer linearen Bewegung durch eine schmale Öffnung im Gehäuse einschiebbar ist.

Vorzugsweise ist die Trägerplatte des Kartenträgers im eingeschobenen Zustand parallel zu einer Hauptplatine des Computers angeordnet. Somit ist sie auch parallel zur Hauptplatine einführbar respektive herausziehbar. Dadurch liegt auch im Computer insgesamt eine kompakte Anordnung vor, im Gegensatz zu der üblichen Anordnung, in welcher Erweiterungskarten senkrecht zum Motherboard angeordnet sind.

In einer weiteren bevorzugten Ausführungsform der Erfindung ist der Computer zur passiven Kühlung während des Betriebes vorgesehen ist, wobei während des Betriebes vorgesehen ist, dass der Computer aufrecht steht, und in diesem Zustand die Trägerplatte und die Hauptplatine senkrecht angeordnet sind und passiv gekühlt werden. Diese passive Kühlung geschieht dabei durch einen senkrecht verlaufenden Luftstrom, der unter anderem in den Zwischenräumen zwischen diesen senkrecht angeordneten Platinen von Motherboard, Trägerplatte und Erweiterungskarte(n) verläuft. Ein solcher Luftstrom entsteht automatisch durch die Kaminwirkung in diesen Zwischenräumen. "Passive Kühlung" bedeutet insbesondere, dass kein Ventilator zur Kühlung der elektronischen Bauelemente des Computers, insbesondere des Prozessors, erforderlich ist.

In einer bevorzugten Ausfiihrungsform der Erfindung weist die Träger-Steckverbindung beim Einstecken vorlaufende Führungselemente zur Führung des Steckers, bevor der Stecker beim Einschieben des Kartenträgers in den Kommunikationsanschluss des Computers einfährt, auf. Vorzugsweise weist die Träger-Steckverbindung zudem Speisekontakte für eine elektrische Speisung des Kartenträgers auf, welche beim Herausziehen des Kartenträger erst nach den übrigen Kontakten, insbesondere nach Buskontakten der Träger-Steckverbindung unterbrochen werden. Vorzugsweise weist die Träger-Steckverbindung ferner Signalkontakte für eine Signalleitung des Kartenträgers auf, wobei diese Signalkontakte beim Herausziehen des Kartenträgers vor den übrigen Kontakten der Träger-Steckverbindung unterbrochen werden. Damit kann eine Hot-Plug-Fähigkeit der Erweiterungskarten unterstützt werden.

In einer bevorzugten Ausführungsform der Erfindung weist der Kartenträger mehrere Kommunikationsanschlüsse auf, vorzugsweise entsprechend verschiedenen Kommunikationsprotokollen. Diese Kommunikationsanschlüsse sind über entsprechende Protokollkonverter oder Bridges an die Kommunikationsschnittstelle zur Hauptplatine angeschlossen und können so mit dieser kommunizieren.

Ein Anschlussdetekor ist dazu eingerichtet, die Identität von Geräten, die an diese Kommunikationsanschlüsse angeschlossen sind, zu bestimmen, sowie vorzugsweise auch weitere Parameter der Geräte, und diese Informationen über die Träger-Steckverbindung an die Hauptplatine des Computer zu übermitteln. Diese Übermittlung geschieht über eine eigene Status-Schnittstelle oder über dieselbe Kommunikationsschnittstelle der Träger-Steckverbindung, mit welcher auch die Geräte mit der Hauptplatine kommunizieren. Anhand der Identität und ggf. der Parameter der Geräte kann eine Systemsoftware des Computers zur Kommunikation mit den Geräten konfiguriert werden. Damit ist es möglich, verschiedene Typen von Geräten alle mit demselben Typ von Kartenträger einzusetzen, ohne den Kartenträger anpassen zu müssen. Der Kartenträger trägt ein oder mehrere der Geräte mechanisch, und die Geräte sind an jeweils einen der Kommunikationsanschlüsse angeschlossen. Die Systemsoftware kann dank der Identifikation mittels des Anschlussdetekors auf dem Kartenträger automatisch entsprechend den aktuell eingesteckten Gerätetypen konfiguriert angepasst werden.

Weitere bevorzugte Ausführungsformen gehen aus den abhängigen Patentansprüchen hervor.

### KURZE BESCHREIBUNG DER ZEICHNUNGEN

Im folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figur 1: eine aufgeschnittene Ansicht eines Computers mit einem Kartenträger gemäss der Erfindung;
- Figur 2: einen Kartenträger;
- Figur 3: einen Ausschnitt des Computergehäuses mit einem Einschub für einen Kartenträger;
- Figur 4: den Einschub mit einem eingesetztem Kartenträger;
- Figuren 5 und 6: einen Stecker einer Adapter-Steckverbindung; und
- Figur 7: einenn Aufbau eines Kartenträger in einer anderen Ausführungsform.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### WEGE ZUR AUSFÜHRUNG DER ERFINDUNG

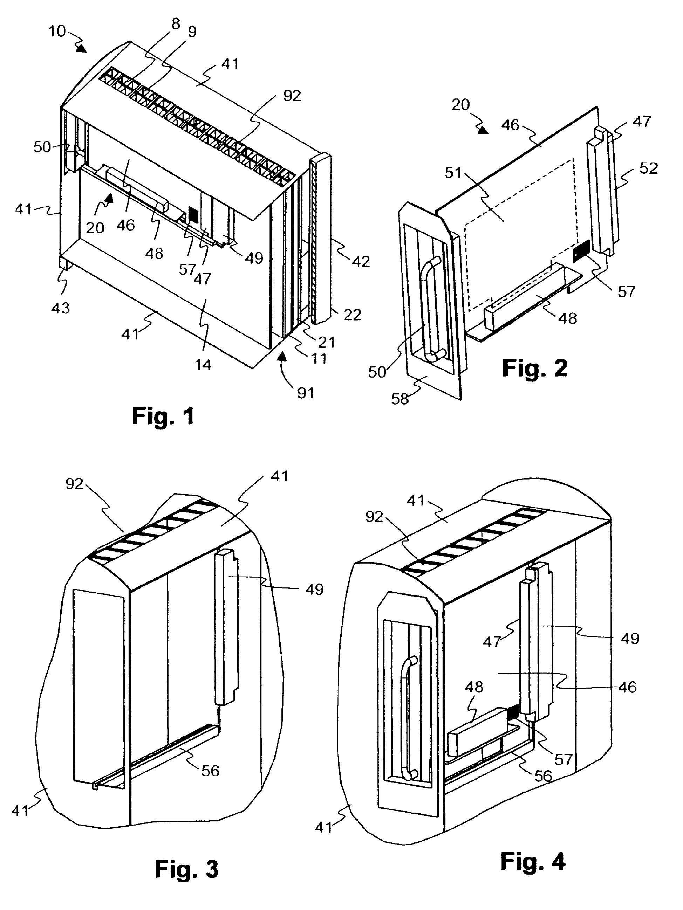

Die **Figur 1** zeigt, in einer teilweisen aufgeschnittenen Ansicht, einen Computer 10 mit einem Gehäuse 41. Das Gehäuse 41 ist beispielsweise durch ein Gehäuseverschalung 42 verkleidet und mit Füssen 43 über die Standfläche erhöht. Das Gehäuse 41 bildet das tragende Gerüst, an welchem die Komponenten oder Baugruppen des Computers wie Prozessor(en), flüchtiger Hauptspeicher (RAM), Massenspeicher wie Festplattenspeicher, CD und/oder DVD-Laufwerke, Schnittstellen-Adapter, Netzteil und/oder Akkus, etc. montiert sind. Diese Komponenten sind beiderseits eines Kühlkanals, bestehend aus mehreren Einzelkanälen 9, angeordnet. Der Kühlkanal verläuft senkrecht über die ganze Höhe des Gehäuses 41 und wird durch Kühlkörper oder Kühlplatten mit Kühlrippen 8, beispielsweise ein Prozessorkühlkörper 11 und ein Festplattenkühlkörper 21, definiert oder gebildet. Im Kühlkanal entsteht ein Luftstrom von einer Lufteintrittsöffnung 91 zu einer Luftaustrittsöffnung 92, welcher die Wärme von den Kühlkörpern aufnimmt und weg transportiert. Dem entsprechend ist der Computer 10 dazu vorgesehen, in der gezeigten Lage, also mit senkrecht angeordneten Kühlplatten, betrieben zu werden. Dabei ist im Betriebszustand auch ein Motherboard 14 (Hauptplatine) senkrecht angeordnet. Das Motherboard 14 ist parallel zum Prozessorkühlkörper 11 angeordnet und trägt den Prozessor sowie weitere elektronische Bauelemente des Computers.

Ein Kartenträger 20 ist mit einer Trägerplatte 46 parallel zum Motherboard 14 angeordnet. Der Kartenträger 20 für sich alleine ist in der **Figur 2** abgebildet. Er weist einerseits eine Träger-Steckverbindung 47 mit einem Stecker 52 auf, der in einen Kommunikationsanschluss oder Slot 49 des Computers 10 einsteckbar ist. Andererseits weist er eine oder mehrere Adapter-Steckverbindungen 48 auf, in welche jeweils eine Erweiterungskarte 51 einsteckbar ist. Ein Handgriff oder Bügel 50 dient zum Herausziehen des Kartenträgers 20. In der **Figur 2** ist eine Erweiterungskarte 51 auf der sichtbaren Seite der Trägerplatte 46 strichliert eingezeichnet. Vorzugsweise ist auch auf der nicht sichtbaren Seite eine Erweiterungskarte 51 in einer korrespondierenden zweiten Adapter-Steckverbindung einsteckbar. Die Erweiterungskarte(n) 51 ist/sind dabei ebenfalls parallel zur Trägerplatte 46 und zum Motherboard 14 und somit senkrecht angeordnet. Dadurch können auch die Erweiterungskarten 51 durch einen vertikal verlaufenden Luftstrom passiv gekühlt werden. In weiteren Ausführungsformen der Erfindung liegen mehr als zwei, parallel zueinander angeordnete Erweiterungskarten 51 vor, welche beispielsweise über parallel zueinander angeordnete Adapter-Steckverbindungen 48 kontaktiert und gehalten sind.

Eine oder mehrere der Erweiterungskarten 51 können über den oder die Adapter-Steckverbindungen 48 durch einen anderen Kommunikationsbus als jenen der Träger-Steckverbindung 47 angesprochen werden. Dazu weist der Kartenträger 20 in einer bevorzugten Ausführungsform der Erfindung einen Konverter 57 auf, welcher die unterschiedlichen Kommunikationsprotokolle ineinander umwandelt. Vorzugsweise entspricht das Kommunikationsprotokoll der Träger-Steckverbindung 47 einem PCI-Express-Standard ("Peripheral Component Interconnect Express", abgekürzt: "PCIe" oder "PCI-E"). Dies ist ein Erweiterungsstandard zur Verbindung zu Peripheriegeräten eines Computers. Das Kommunikationsprotokoll einer Adapter-Steckverbindung 48 entspricht entweder auch dem PCI-Express Standard, so dass keine Protokollkonversion erforderlich ist, und eine galvanische Verbindung zwischen Träger-Steckverbindung 47 und Adapter-Steckverbindung 48 vorliegen kann. Oder das Kommunikationsprotokoll einer Adapter-Steckverbindung 48 entspricht einem anderen Standard, beispielsweise dem älteren PCI-Standard, so dass ein Konverter 57 erforderlich ist. In einer bevorzugten Ausführungsform der Erfindung weist der Kartenträger 20 genau eine erste Adapter-Steckverbindung 48 gemäss dem PCI-Express-Standard und genau eine zweite Adapter-Steckverbindung 48 gemäss dem PCI-Standard auf. Alternativ weist sie genau zwei zweite Adapter-Steckverbindungen 48 gemäss dem PCI-Standard auf.

**Figur 3** zeigt einen Ausschnitt des Computergehäuses 10 mit einem Einschub für einen Kartenträger 20. Der Kartenträger 20 ist dabei durch eine Öffnung im Gehäuse 41 entlang einer Einschubführung 56 einschiebbar, bis die Träger-Steckverbindung 47 in den Slot 49 einfährt und gegebenenfalls einrastet. Dies ist in der **Figur 4** gezeigt. Eine Frontplatte 58 des Kartenträgers 20 deckt dabei die Öffnung am Gehäuse 41 ab.

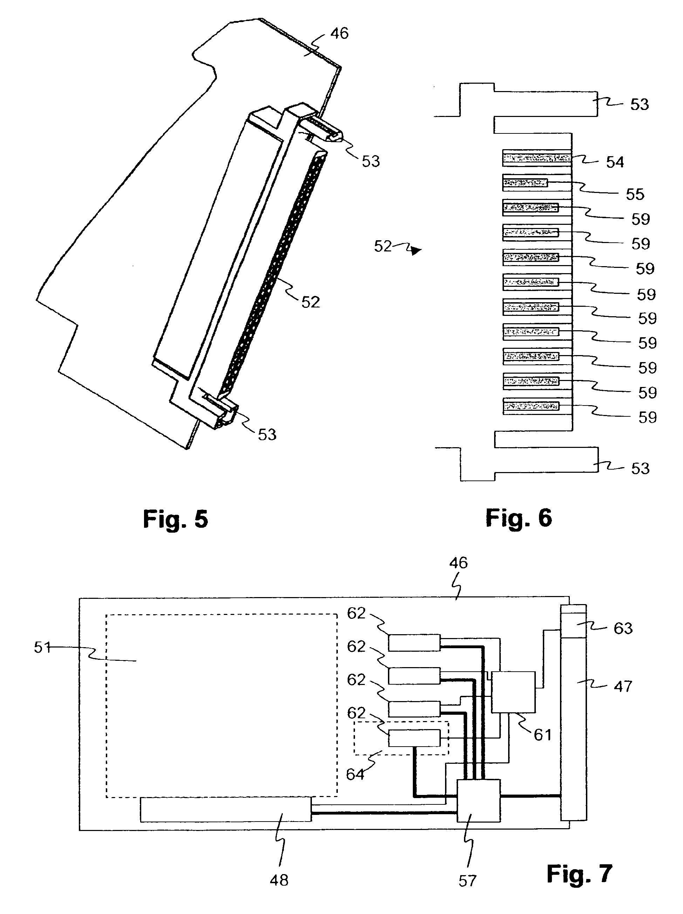

**Figur 5** zeigt einen Stecker 52 einer Adapter-Steckverbindung 47. Der Stecker 52 weist vorlaufende Führungselemente 53, Führungsnocken oder Führungsstifte auf, sowie vorlaufende Speisekontakte 54 und nachlaufende Signalkontakte 55. Die Führungselemente 53 führen den Stecker 52 beim Einfahren in den Slot 49, bevor die elektrischen Kontakte einfahren. Die Speisekontakte 54 sind bezüglich der übrigen Kontakte vorlaufend, so dass sie beim Einfahren des Steckers 52 als erste einen Kontakt herstellen. Umgekehrt werden die Speisekontakte 54 beim Herausziehen nach den übrigen Kontakten, insbesondere nach Buskontakten 59, als letzte unterbrochen. **Figur 6** zeigt schematisch einen Querschnitt durch eine Ebene des Steckers 52 mit entsprechend vorversetzten respektive rückversetzten Kontakten, unter der Annahme, dass die gegenüberliegenden Kontakte in der zum Stecker korrespondierenden Buchse alle die gleiche Höhe aufweisen. Natürlich können auch die unterschiedlich langen Kontakte alle oder zum Teil in der Buchse anstelle des Steckers vorliegen.

Die Signalkontakte 55 (oder auch nur ein einzelner Signalkontakt 55) sind bezüglich der übrigen Kontakte oder Buskontakte 59 nachlaufend, so dass sie beim Einfahren des Steckers 52 als letzte einen Kontakt herstellen, insbesondere nach den Buskontakten. Umgekehrt wird beim Ausfahren des Steckers 52 als erstes mindestens ein Signalkontakt 55 unterbrochen, worauf die Erweiterungskarten 51, ausgelöst durch diesen Unterbruch, kontrolliert herunterfahren können, bevor die Signalkontakte und die Speisung 54 unterbrochen werden.

**Figur 7** zeigt schematisch einen inneren Aufbau eines Kartenträgers 20 in einer bevorzugten Ausführungsform der Erfindung. Dieser innere Aufbau kann mit dem äusseren Aufbau gemäss den anderen Figuren kombiniert sein. Der Kartenträger 20 mit der Trägerplatte 46 weist vorzugsweise die bereits beschriebenen Träger-Steckverbindung 47, die Adapter- Steckverbindung 48 und einen Konverter 57 zur Konversion zwischen den Schnittstellen dieser beiden Steckverbindungen auf. Vorzugsweise ist dies auch hier eine Konversion zwischen PCI (für eine Erweiterungskarte 51) und PCI-Express. Der Kartenträger 20 weist zudem weitere Kommunikationsanschlüsse 62 auf. Diese sind ebenfalls über den Konverter 57 oder über eigene Konverter (nicht eingezeichnet) an die Träger-Steckverbindung 47 angeschlossen. Die entsprechenden Konverter 57 bewerkstelligen die Kommunikation zwischen der Träger-Steckverbindung 47 und dem jeweiligen Kommunikationsanschluss 62. Die Kommunikationsanschlüsse 62 sind beispielsweise serielle Schnittstellen nach einem der Standards RS-232, USB, USB-2, Firewire, etc. oder Schnittstellen für Festplatten wie SATA, I2C, SMB etc.

Der Kartenträger 20 weist vorzugsweise einen Anschlussdetekor 61 auf, welcher die Kommunikationsanschlüsse 62 überwacht und dazu eingerichtet ist, die Belegung der Kommunikationsanschlüsse 62 und Information über angeschlossene weitere Geräte 64 zu bestimmen. Dazu kann der Anschlussdetekor 61 über die Kommunikationsanschlüsse 62 mit den angeschlossenen Geräten kommunizieren. Information über angeschlossene Geräte 64 umfasst beispielsweise eine Identität eines angeschlossenen Gerätes, insbesondere den Typ des Gerätes wie beispielsweise "GSM-Modul", "WLAN-Schnittstelle", "GPS-Einheit", "Harddisk", "DVD-Drive" etc, sowie Parameter des Gerätes. Eines oder mehrere solcher Geräte sind am Kartenträger 20 montiert, d.h. mechanisch auf diesem befestigt und durch diesen getragen. Der Anschlussdetekor 61 ist dazu eingerichtet, diese Informationen über eine Status-Schnittstelle 63 an eine Konfigurationseinheit des Computers 10 zu übermitteln. Die Konfigurationseinheit ist vorzugsweise in Software implementiert und konfiguriert die Systemsoftware des Computers 10 indem beispielsweise zu den detektierten und angeschlossenen Geräten 64 passende Treiber geladen werden.

In der **Figur 7** sind der Anschlussdetekor 61 und der Konverter 57 als separate Einheiten eingezeichnet, sie können aber hardwaremässig durch eine einzige Einheit realisiert sein. Auch kann die Status-Schnittstelle 63 als Teil der mechanischen Träger-Steckverbindung 47 aber separat von der PCI-Express-Schnittstelle zum übrigen Computer 10 geführt sein, oder aber die Information über die Geräte wird nicht über eine eigene physische Status-Schnittstelle 63, sondern auch über die PCI-Express-Schnittstelle geführt.

### BEZUGSZEICHENLISTE

- 8: Kühlrippe
- 9: Luftkanal
- 10: Computer
- 11: Prozessorkühlkörper
- 14: Hauptplatine, Motherboard
- 21: Festplattenkühlkörper
- 22: Festplatte
- 20: Kartenträger
- 41: Gehäuse
- 42: Gehäuseverschalung
- 43: Füsse
- 46: Trägerplatte
- 47: Träger-Steckverbindung
- 48: Adapter- Steckverbindung
- 49: Kommunikationsanschluss, Slot
- 50: Bügel
- 51: Erweiterungskarte
- 52: Stecker
- 53: Führungselemente
- 54: Speisekontakte
- 55: Signalkontakte
- 56: Einschubführung
- 57: Konverter
- 58: Frontplatte
- 59: Buskontakte
- 61: Anschlussdetekor
- 62: Kommunikationsanschluss
- 63: Status-Schnittstelle
- 91: Lufteintrittsöffnung
- 92: Luftaustrittsöffnung

## Patentansprüche

1. Computergehäuse (41) zur freistehenden Verwendung, aufweisend einen Computer (10) mit Steckplätzen für die Aufnahme von Erweiterungskarten, **dadurch gekennzeichnet, dass** der Computer zur Aufnahme der Erweiterungskarten (51) einen Kartenträger (20) aufweist, welcher
- eine Träger-Steckverbindung (47) aufweist und über die Träger-Steckverbindung (47) durch Einschieben des Kartenträgers in das Computergehäuse (41) mit einem Kommunikationsanschluss (49) des Computers (10) verbindbar ist,
- mindestens eine Adapter-Steckverbindung (48) aufweist, in welche eine Erweiterungskarte (51) einsteckbar ist,
- wobei der Kartenträger (20) eine Kommunikationsverbindung zwischen der Träger-Steckverbindung (47) und der mindestens eine Adapter-Steckverbindung (48) aufweist.

2. Computergehäuse (41) gemäss Anspruch 1, wobei der Kartenträger (20) eine im wesentlichen ebene Trägerplatte (46) aufweist, die Richtung der Bewegung beim Einstecken und Ausstecken der Träger-Steckverbindung (47) parallel zur Ebene der Trägerplatte (46) verläuft, und eingesteckte Erweiterungskarten (51) parallel zur Ebene der Trägerplatte (46) angeordnet sind.

3. Computergehäuse (41) gemäss mindestens einem der bisherigen Ansprüche, wobei der Kartenträger (20) durch Führungselemente (56) im Computergehäuse (41) geführt ist und mit einer linearen Bewegung in das Computergehäuse (41) einführbar respektive herausziehbar ist.

4. Computergehäuse (41) gemäss mindestens einem der bisherigen Ansprüche, wobei die Trägerplatte (46) des Kartenträgers (20) parallel zum Motherboard (14) des Computers (10) angeordnet ist und parallel zum Motherboard (14) einführbar respektive herausziehbar ist.

5. Computergehäuse (41) gemäss Anspruch 4, wobei der Computer (10) zur passiven Kühlung während des Betriebes vorgesehen ist, und dazu während des Betriebes vorgesehen ist, dass der Computer (10) aufrecht steht, und in diesem Zustand die Trägerplatte (46) und das Motherboard (14) senkrecht angeordnet sind.

6. Computergehäuse (41) gemäss mindestens einem der bisherigen Ansprüche, wobei die Träger-Steckverbindung (47) beim Einstecken vorlaufende Führungselemente (53) zur Führung des Steckers (52), bevor der Stecker (52) beim Einschieben des Kartenträgers (20) in den Kommunikationsanschluss (49) des Computers (10) einfährt, aufweist.

7. Computergehäuse (41) gemäss mindestens einem der bisherigen Ansprüche, wobei die Träger-Steckverbindung (47) Speisekontakte (54) für eine elektrische Speisung des Kartenträgers (20) aufweist, welche beim Herausziehen des Kartenträgers (20) nach den übrigen Kontakten der Träger-Steckverbindung (47) unterbrochen werden.

8. Computergehäuse (41) gemäss mindestens einem der bisherigen Ansprüche, wobei die Träger-Steckverbindung (47) Signalkontakte (55) für eine Signalleitung des Kartenträgers (20) aufweist, wobei diese Signalkontakte (55) beim Herausziehen des Kartenträgers (20) vor den übrigen Kontakten der Träger-Steckverbindung (47) unterbrochen werden.

9. Computergehäuse (41) gemäss mindestens einem der bisherigen Ansprüche, wobei die Träger-Steckverbindung (47) eine PCI-Express Schnittstelle ist und mindestens eine Adapter-Steckverbindung (48) eine PCI-Express Schnittstelle ist.

10. Computergehäuse (41) gemäss mindestens einem der bisherigen Ansprüche, wobei die Träger-Steckverbindung (47) eine PCI-Express Schnittstelle ist und mindestens eine Adapter-Steckverbindung (48) eine PCI Schnittstelle ist und der Kartenträger (20) einen Konverter (57) zwischen dem PCI-Express-Bus der Träger-Steckverbindung (47) und der PCI Schnittstelle der Adapter-Steckverbindung (48) aufweist.

11. Kartenträger (20) zum Einsetzen in ein Computergehäuse (41) und zur Aufnahme von Erweiterungskarten (51) eines Computers (10), wobei der Kartenträger (20)
- eine Träger-Steckverbindung (47) aufweist und über die Träger-Steckverbindung (47) durch Einschieben des Kartenträgers in das Computergehäuse (41) mit einem Kommunikationsanschluss (49) des Computers (10) verbindbar ist,
- mindestens eine Adapter-Steckverbindung (48) aufweist, in welche eine Erweiterungskarte (51) einsteckbar ist, und
wobei der Kartenträger (20) eine Kommunikationsverbindung zwischen der Träger-Steckverbindung (47) und der mindestens eine Adapter-Steckverbindung (48) aufweist.

12. Kartenträger (20) gemäss Anspruch 11, wobei die Träger-Steckverbindung (47) eine PCI-Express Schnittstelle ist und mindestens eine Adapter-Steckverbindung (48) eine PCI Schnittstelle ist und der Kartenträger (20) einen Konverter (57) zwischen dem PCI-Express-Bus der Träger-Steckverbindung (47) und der PCI Schnittstelle der Adapter-Steckverbindung (48) aufweist.

13. Kartenträger (20) gemäss Anspruch 11 oder 12, aufweisend Kommunikationsanschlüsse (62) zur Verbindung mit weiteren Geräten, wobei diese weiteren Geräte am Kartenträger (20) befestigt sind, sowie einem Anschlussdetekor (61) zur Ermittlung von Informationen über diese weiteren Geräte via einen der Kommunikationsanschlüsse (62) und zur Übermittlung dieser Informationen über die Träger-Steckverbindung (47) ausgebildet ist.

14. Kartenträger (20) gemäss Anspruch 13, wobei die vom Anschlussdetekor (61) ermittelte und übermittelte Information einen Typ der weiteren Geräte beinhaltet.

15. Kartenträger (20) gemäss einem der Ansprüche 11 bis 14, wobei die Träger-Steckverbindung (47) Signalkontakte (55) für eine Signalleitung des Kartenträgers (20) aufweist, wobei diese Signalkontakte (55) beim Herausziehen des Kartenträgers (20) vor den übrigen Kontakten der Träger-Steckverbindung (47) unterbrochen werden.
